# EUROPEAN PATENT SPECIFICATION

(11) **EP 4 307 830 B1**
(45) Date of publication and mention of the grant of the patent: **06.05.2026**
(21) Application number: 22767196.3
(22) Date of filing: 09.03.2022
(51) Int. Cl.: G05D 23/19, C23C 16/46, H05B 3/00, H01L 21/205, H01L 21/31, C23C 16/52, H05B 1/02, H05B 3/46, H01L 21/20

(54) **SUBSTRATE PROCESSING APPARATUS, ANOMALY DETECTING METHOD, AND METHOD FOR MANUFACTURING SEMICONDUCTOR APPARATUS**
SUBSTRATVERARBEITUNGSVORRICHTUNG, ANOMALIEDETEKTIONSVERFAHREN UND VERFAHREN ZUR HERSTELLUNG EINER HALBLEITERVORRICHTUNG
APPAREIL DE TRAITEMENT DE SUBSTRAT, PROCÉDÉ DE DÉTECTION D'ANOMALIE ET PROCÉDÉ DE FABRICATION D'APPAREIL À SEMI-CONDUCTEUR

(30) Priority: 12.03.2021 JP 2021040823
(43) Date of publication of application: 17.01.2024
(73) Proprietor: Kokusai Electric Corporation, Tokyo 101-0045 (JP)
(72) Inventor: KAWAHARA, Yoshitaka, Toyama-shi, Toyama 939-2393 (JP); MAEDA, Ikuhiro, Toyama-shi, Toyama 939-2393 (JP)
(74) Representative: Verscht, Thomas Kurt Albert
(86) International application number: PCT/JP2022/010306
(87) International publication number: WO 2022/191242

(56) References cited:
- JP-A- 2009 070 682
- JP-A- 2009 070 682
- JP-A- 2009 076 531
- JP-A- 2009 076 531
- JP-A- 2009 148 100
- US-B2- 10 633 742

## Description

### [Technical Field]

The present disclosure relates to a substrate processing apparatus, an abnormality detecting method and a method of manufacturing a semiconductor device.

### [Related Art]

In a substrate processing apparatus used in a semiconductor manufacturing field, a film is formed on a substrate while heating the substrate with a heat from a heater. A semiconductor element such as a thyristor is used for a power control of the heater so as to suppress an overheating of the substrate. In Patent Document 1, disclosed is a technique of connecting a plurality of power supplies in order to stably supply an electric power to a power supply target. In addition, in Patent Document 2, disclosed is a technique of detecting at least one among a current, a voltage or the electric power supplied to the heater used in the substrate processing apparatus and detecting a state of the heater (for example, an abnormal heat generating state and a disconnection state) from detection results.

In the semiconductor manufacturing field, in consideration of an influence on the substrate processing apparatus and the substrate, it is desired to reliably detect an occurrence of a failure in components (including a heater wire) that constitute a drive circuit.

### [Related Art Document]

### [Patent Documents]

Patent Document 1: International Patent Publication No. WO2019/053869
Patent Document 2: Japanese Patent Laid-Open No. H11-54244

With regard to the prior art further attention is drawn to JP 2009 070682 A from which a heater control device is known.

### [Disclosure]

### [Technical Problem]

It is an object of the present disclosure to provide a technique capable of detecting that a failure has occurred in a component constituting a circuit.

### [Technical Solution]

The present invention relates to a substrate processing apparatus as defined in claim 1.

Further, the present invention relates to an abnormality detecting method as defined in claim 12.

Furthermore, the present invention relates to a method of manufacturing a semiconductor device as defined in claim 13.

Preferred embodiments of the present invention are disclosed in the dependent claims.

### [Advantageous Effects]

According to the present disclosure, it is possible to detect that a failure has occurred in a component constituting a circuit.

### [Brief Description of Drawings]

FIG. 1 is diagram schematically illustrating a side cross-section of a substrate processing apparatus according to embodiments of the present disclosure.
FIG. 2 is diagram schematically illustrating a functional configuration of a control system used in the substrate processing apparatus according to the embodiments of the present disclosure.
FIG. 3 is diagram schematically illustrating a functional configuration of an apparatus controller used in the substrate processing apparatus according to the embodiments of the present disclosure.
FIG. 4 is diagram schematically illustrating a drive circuit of a heater used in the substrate processing apparatus according to the embodiments of the present disclosure.
FIG. 5 is diagram schematically illustrating a functional configuration of an abnormality detecting controller used in the substrate processing apparatus according to the embodiments of the present disclosure.

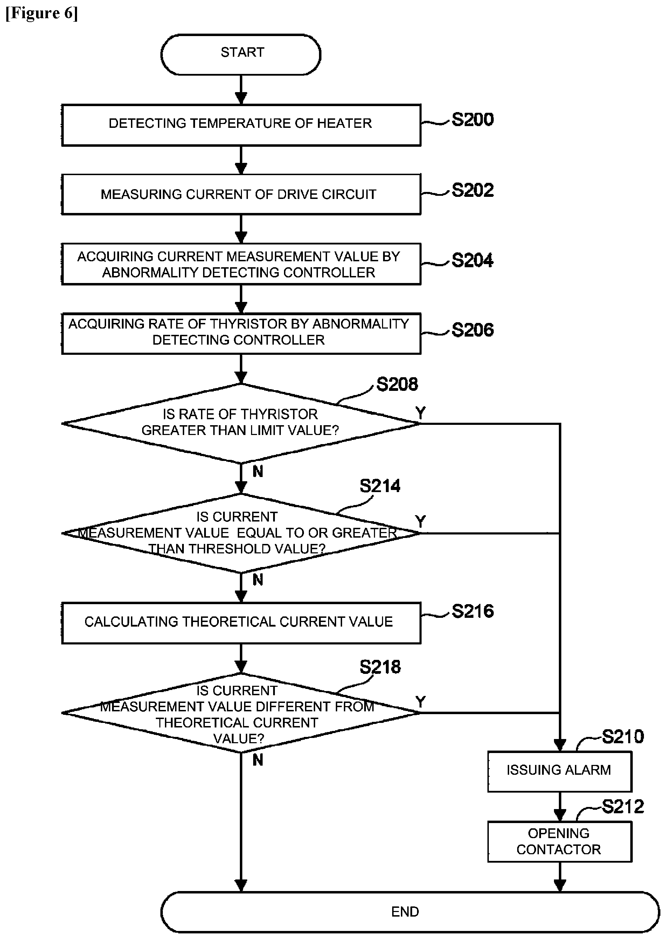

FIG. 6 is a flow chart schematically illustrating a first abnormality detecting method according to the embodiments of the present disclosure.

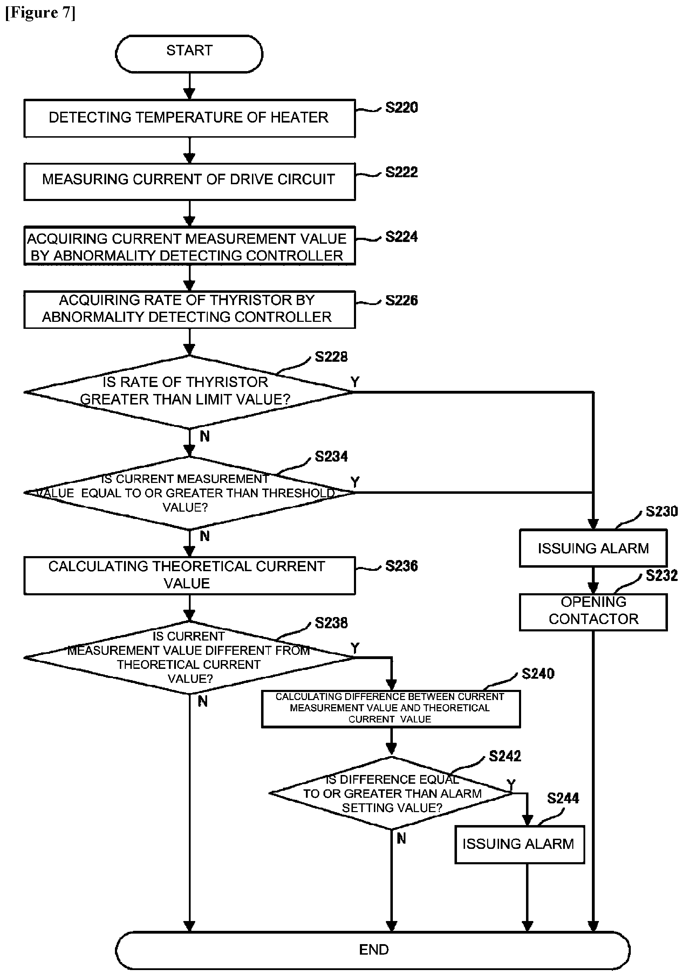

FIG. 7 is a flow chart schematically illustrating a second abnormality detecting method according to the embodiments of the present disclosure.
FIG. 8 is a graph schematically illustrating a relationship between an output setting value of a thyristor and an ammeter monitor value.
FIG. 9 is diagram schematically illustrating a drive circuit of a heater used in a substrate processing apparatus according to other embodiments of the present disclosure.

### [Detailed Description]

Hereinafter, embodiments according to the present disclosure will be described with reference to the drawings. In the present specification, the drawings used in the following descriptions are all schematic. For example, a relationship between dimensions of each component and a ratio of each component shown in the drawing may not always match the actual ones. Further, even between the drawings, the relationship between the dimensions of each component and the ratio of each component may not always match.

A processing apparatus according to the embodiments of the present disclosure is configured as a substrate processing apparatus 10 used in a substrate processing serving as a part of a manufacturing process of a semiconductor device.

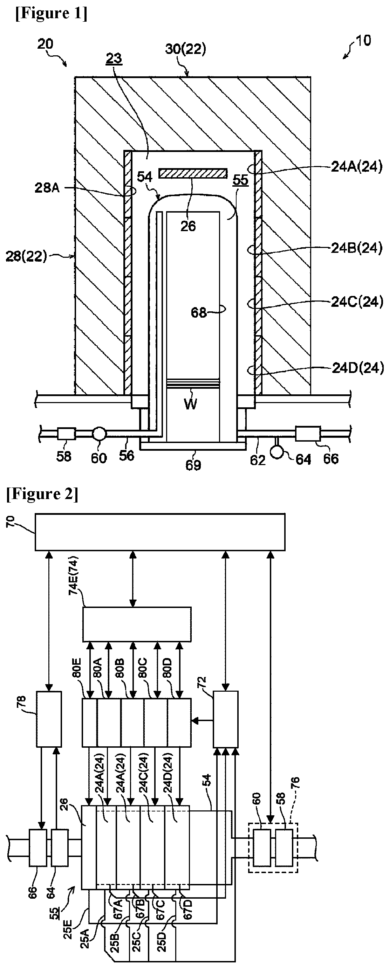

As shown in FIG. 1, the substrate processing apparatus 10 according to the present embodiments includes a heating apparatus 20, a reaction tube 54 and a boat 68.

As shown in FIG. 1, the heating apparatus 20 is an apparatus configured to heat a substrate W to be processed. The heating apparatus 20 includes a furnace structure 22 and a side heater 24 and a ceiling heater 26 serving as heat generators (which are heat generating structures) arranged at an inner side of the furnace structure 22.

The furnace structure 22 is provided by laminating a plurality of heat insulators. However, the present disclosure is not limited to thereto, and the furnace structure 22 may be constituted by a single heat insulator.

Further, the furnace structure 22 is of a tubular shape (for example, a cylindrical shape, an oval cylindrical shape or a polygonal cylindrical shape) with a closed end. The furnace structure 22 according to the present embodiments is installed such that an up-and-down direction of the heating apparatus 20 is an axial direction of the furnace structure 22, an upper end of the furnace structure 22 corresponding to one end in the axial direction is closed, and a lower end of the furnace structure 22 corresponding to the other end in the axial direction is open. In addition, hereinafter, an inner space of the furnace structure 22 may also be referred to as a "furnace internal space 23". The side heater 24 and the ceiling heater 26 are arranged in the furnace internal space 23. In addition, the reaction tube 54 is accommodated in the furnace internal space 23.

The furnace structure 22 includes a side wall structure 28 of a cylindrical shape and a ceiling structure 30 configured to close an upper end of the side wall structure 28. In addition, according to the present embodiments, the furnace internal space 23 is defined by the side wall structure 28 and the ceiling structure 30.

The side heater 24 is arranged at an inner side (that is, an inner side in a radial direction) of the side wall structure 28. According to the present embodiments, the side heater 24 is attached to an inner surface 28A of the side wall structure 28 so as to cover the inner surface 28A. The side heater 24 is configured to generate a heat when an electric power is supplied, and to heat the furnace internal space 23 from a side of the furnace internal space 23.

The side heater 24 is of a cylindrical shape, and is continuously provided in a circumferential direction along the inner surface 28A of the side wall structure 28. In addition, the side heater 24 is divided into a plurality of structures (heat generating zones) in the axial direction of the furnace structure 22. According to the present embodiments, the axial direction of the furnace structure 22, an axial direction of the side heater 24 and the up-and-down direction of the heating apparatus 20 are the same. Further, the side heater 24 is configured to be capable of controlling a heat generating temperature for each divided heat generating zone.

According to the present embodiments, as shown in FIGS. 1 and 2, for example, the side heater 24 is divided into four heat generating zones in the axial direction thereof. Hereinafter, the heat generating zones of the side heater 24 may also be referred to as a heat generating zone 24A, a heat generating zone 24B, a heat generating zone 24C and a heat generating zone 24D, respectively, in this order from an upper portion to a lower portion of the heating apparatus 20. However, the present disclosure is not limited to thereto, and the side heater 24 may be divided into two or three heat generating zones in the axial direction thereof, or may be divided into five or more heat generating zones in the axial direction thereof. Alternatively, the side heater 24 may not be divided into a plurality of structures. That is, the side heater 24 may be constituted by a single structure (single heat generating zone). Further, according to the present embodiments, the heat generating temperature of the side heater 24 is controlled by a temperature controller 72 described later.

The ceiling heater 26 is arranged below the ceiling structure 30. Specifically, the ceiling heater 26 is arranged between the reaction tube 54 and the ceiling structure 30 in the up-and-down direction of the heating apparatus 20. The ceiling heater 26 is configured to generate a heat when an electric power is supplied, and to heat the furnace internal space 23 from thereabove. For example, the ceiling heater 26 according to the present embodiments is of a plate shape. In addition, according to the present embodiments, a heat generating temperature of the ceiling heater 26 is controlled by the temperature controller 72 described later.

As described above, by heating the furnace internal space 23 from the side thereof by the heat generated by the side heater 24 and from thereabove by the heat generated by the ceiling heater 26, an inside of a process chamber 55 is heated through the reaction tube 54 accommodated in the furnace internal space 23, and an inner temperature of the process chamber 55 is elevated. Thereby, the substrate W charged (loaded) in the process chamber 55 is heated.

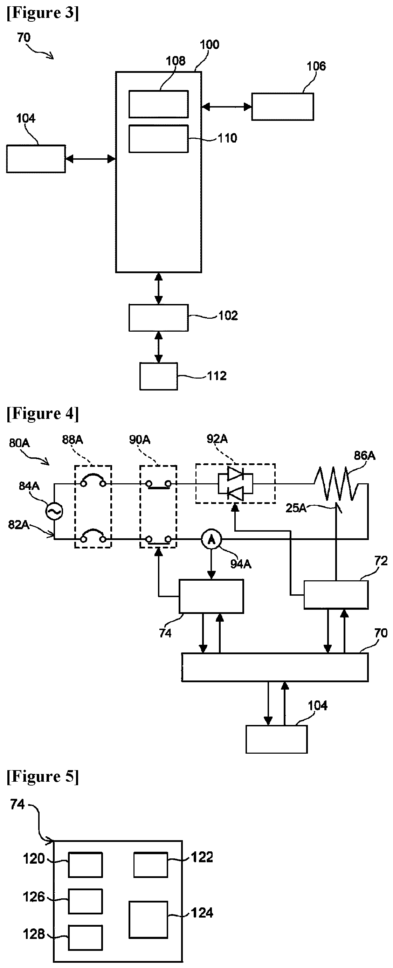

As shown in FIG. 2, temperature sensors serving as temperature detectors are provided at the heat generating zones of the side heater 24, respectively. Specifically, each of the temperature sensors is installed in the vicinity of a heater wire (see FIG. 4) provided in each of the heat generating zones. For example, according to the present embodiments, the temperature sensor installed in the heat generating zone 24A is represented by a reference numeral 25A, the temperature sensor installed in the heat generating zone 24B is represented by a reference numeral 25B, the temperature sensor installed in the heat generating zone 24C is represented by a reference numeral 25C, and the temperature sensor installed in the heat generating zone 24D is represented by a reference numeral 25D. The temperature sensors 25A, 25B, 25C and 25D are configured to detect temperatures of the heat generating zones 24A, 24B, 24C and 24D, respectively. A detection value (detection temperature) detected by each of the temperature sensors 25A, 25B, 25C and 25D is configured to be transmitted to the temperature controller 72 serving as a temperature regulator. Further, it is sufficient that the temperature sensors 25A, 25B, 25C, and 25D are configured to be capable of detecting the temperatures of the heat generating zones to be measured, respectively, and a thermometer or thermocouples may be used as each of the temperature sensors 25A, 25B, 25C, and 25D, for example.

As shown in FIG. 2, a temperature sensor 25E serving as a temperature detector (which is a temperature detecting structure) is provided at the ceiling heater 26. Specifically, the temperature sensor 25E is installed in the vicinity of a heater wire (see FIG. 4) included in the ceiling heater 26. The temperature sensor 25E is configured to detect a temperature of the ceiling heater 26. A detection value (detection temperature) detected by the temperature sensor 25E is configured to be transmitted to the temperature controller 72. Further, it is sufficient that the temperature sensor 25E is configured to be capable of detecting the temperature of the ceiling heater 26, and a thermometer or thermocouples may be used as the temperature sensor 25E, for example.

For example, the heating apparatus 20 may include heater driving apparatuses capable of driving the heaters. According to the present embodiments, the heater driving apparatuses are connected to the heat generating zones of the side heater 24 and to the ceiling heater 26, respectively. A driving power is supplied to each heater from each heater driving apparatus. For example, according to the present embodiments, as shown in FIG. 2, a heater driving apparatus 80A is connected to the heat generating zone 24A of the side heater 24, a heater driving apparatus 80B is connected to the heat generating zone 24B, a heater driving apparatus 80C is connected to the heat generating zone 24C, and a heater driving apparatus 80D is connected to the heat generating zone 24D. For example, a heater driving apparatus 80E is connected to the ceiling heater 26. Since configurations of the heater driving apparatuses 80A, 80B, 80C, 80D and 80E are substantially the same, the heater driving apparatus 80A will be described below as an representative example of the heater driving apparatuses 80A, 80B, 80C, 80D and 80E.

As shown in FIG. 4, the heater driving apparatus 80A may include a drive circuit 82A. The drive circuit 82A may include a power supply 84A, a heater wire 86A, a circuit breaker 88A, a contactor 90A, a thyristor 92A serving as a power supplier (which is a power supply structure) and an ammeter 94A serving as a measurer (which is a measuring structure).

The power supply 84A is configured to supply the drive circuit 82A with the electric power used by the heater wire 86A. According to the present embodiments, an AC power supply is used as the power supply 84A. Further, according to the present embodiments, for example, power supplies are connected to drive circuits, respectively. However, the present disclosure is not limited to thereto. For example, the same power supply may be used for a plurality of drive circuits.

The heater wire 86A is a structure configured to generate the heat when the electric power is supplied. The heat generating zone 24A of the side heater 24 is constituted by the heater wire 86A.

The circuit breaker 88A is provided between the power supply 84A and the heater wire 86A in the drive circuit 82A. The circuit breaker 88A is a structure configured to cut off an accident current that flows when a failure or an abnormality occurs in the drive circuit 82A.

The contactor 90A is provided between the circuit breaker 88A and the heater wire 86A in the drive circuit 82A. The contactor 90A is a structure configured to open and close the drive circuit 82A. An opening and closing operation of the contactor 90A is controlled by an abnormality detecting controller 74.

The thyristor 92A is provided between the contactor 90A and the heater wire 86A in drive circuit 82A. The thyristor 92A is a structure configured to control the electric power supplied from the power supply 84A to the heater wire 86A. A switching operation (which is an on and off operation) of the thyristor 92A is controlled by the temperature controller 72.

The ammeter 94A is provided between the contactor 90A and the heater wire 86A in drive circuit 82A. The ammeter 94A is an instrument capable of measuring a current flowing through the drive circuit 82A. A current measurement value measured by the ammeter 94A is configured to be transmitted to the abnormality detecting controller 74.

Further, the temperature sensor 25A is provided in the vicinity of the heater wire 86A. The temperature detected by the temperature sensor 25A is configured to be transmitted to the temperature controller 72.

The reaction tube 54 is accommodated in the furnace internal space 23 of the furnace structure 22. The reaction tube 54 is of a cylindrical shape with a closed end in an axial direction thereof. The reaction tube 54 according to the present embodiments is installed such that the up-and-down direction of the heating apparatus 20 is the axial direction of the reaction tube 54, an upper end of the reaction tube 54 corresponding to one end in the axial direction is closed, and a lower end of the reaction tube 54 corresponding to the other end in the axial direction is open. In addition, hereinafter, an inner space of the reaction tube 54 may also be referred to as the "process chamber 55". The boat 68 is configured to be accommodated in the process chamber 55.

A gas introduction pipe 56 is connected to the reaction tube 54. Specifically, the gas introduction pipe 56 penetrates a lower peripheral wall of the reaction tube 54, bends in the middle, and extends toward an upper portion of the reaction tube 54. An inside of the gas introduction pipe 56 communicates with the process chamber 55 of the reaction tube 54. A process gas supply source (not shown) capable of supplying a process gas for processing the substrate W is connected to the gas introduction pipe 56. The process gas is supplied to the process chamber 55 through the gas introduction pipe 56. For example, in a portion of the gas introduction pipe 56 between the process gas supply source and the reaction tube 54, a flow rate sensor 58 and a flow rate control valve 60 are sequentially installed in this order from an upstream side to a downstream side in a flow direction of the process gas.

Further, a gas exhaust pipe 62 is connected to the reaction tube 54. An inside of the gas exhaust pipe 62 communicates with the process chamber 55 of the reaction tube 54. A pressure sensor 64 and an APC (Automatic Pressure Controller) valve 66 serving as a pressure controller are sequentially installed at the gas exhaust pipe 62 in this order from an upstream side to a downstream side in a flow direction of a gas. The gas exhaust pipe 62 is a pipe through which the gas (the process gas in the present embodiments) in the process chamber 55 is exhausted.

In addition, in the process chamber 55 of the reaction tube 54, a temperature sensor 67A, a temperature sensor 67B, a temperature sensor 67C, and a temperature sensor 67D are sequentially installed in this order from the upper portion of the heating apparatus 20. A detection value (detection temperature) detected by each of the temperature sensors is configured to be transmitted to the temperature controller 72.

The boat 68 is a substrate support (which is a substrate retainer) configured to support a plurality of substrates W in the reaction tube 54. The boat 68 is configured to support the substrates W in a horizontal state in a multistage manner with a predetermined interval therebetween. Further, the boat 68 is attached to an elevator (which is an elevating structure) (not shown) via a cap 69 configured to close the lower end of the reaction tube 54. The boat 68 is configured to be capable of being elevated or lowered in the up-and-down direction of the heating apparatus 20 by the elevator. According to the present embodiments, the substrate W supported by the boat 68 may be transferred (loaded) into the reaction tube 54 or transferred (unloaded) from the reaction tube 54 by an operation of the elevator.

The substrate processing apparatus 10 may further includes a control system. The control system may include: an apparatus controller 70 serving as a control structure (controller); the temperature controller 72 serving as the temperature regulator; the abnormality detecting controller 74 serving as an abnormality detector; a flow rate controller 76 serving as a flow rate control structure; and a pressure controller 78 serving as a pressure regulator.

The apparatus controller 70 functions as a data collection controller. The apparatus controller 70 is configured to collect apparatus data generated by the substrate processing apparatus 10. According to the present embodiments, the apparatus data may include monitor data generated by an operation of each component constituting the substrate processing apparatus 10 when the substrate W is processed by the substrate processing apparatus 10. For example, the monitor data may include: data (for example, an actually measured value) related to the substrate processing such as a process temperature, a process pressure and a flow rate of the process gas when the substrate processing apparatus 10 processes the substrate W; data related to a quality of a product substrate (for example, data such as a thickness of a film and an accumulated thickness of the film); and data related to each component constituting the substrate processing apparatus 10 (for example, data such as a pre-set value, an actually measured value, the number of times the component is used and a usage time of the component such as the reaction tube, the heater, a valve and an MFC). Further, the apparatus data may further include event data related to various apparatus events generated by the substrate processing apparatus 10. For example, the event data may include alarm information for generating various alarms.

Further, data collected when a recipe is executed may also be referred to as "process data". The process data may include: actually measured value data collected at a predetermined time interval (for example, raw waveform data collected from a start to an end of the recipe at the predetermined time interval such as 1 second); and statistical data created by processing the actually measured value data collected with the predetermined time interval at each step in the recipe. The apparatus data may also include the process data. Further, the statistical data may also include values such as a maximum value, a minimum value and an average value. The apparatus data may also include the event data indicating various apparatus events generated during an idling period when the recipe is not executed (for example, when the substrate is not loaded into the substrate processing apparatus 10). For example, the event data may include data indicating a maintenance history.

For example, the apparatus controller 70 is electrically connected to the temperature controller 72, the abnormality detecting controller 74, the flow rate controller 76 and the pressure controller 78 by a LAN (Local Area Network) such as 100 BASE-T. Therefore, each apparatus data can be transmitted or received and each file can be uploaded or downloaded among the temperature controller 72, the abnormality detecting controller 74, the flow rate controller 76 and the pressure controller 78.

For example, the apparatus controller 70 is provided with a port serving as a mounting structure on which a recording medium such as a USB memory serving as an external memory is installed or removed. An OS (operating system) is installed in the apparatus controller 70 corresponding to the port. Further, for example, a host computer (not shown) or a management apparatus (not shown) may be connected to the apparatus controller 70 via a communication network.

The apparatus controller 70 is configured to collect the apparatus data, to quantify an operating state of an apparatus and to display the quantified operating state on a screen. Further, the apparatus controller 70 is configured to execute each function.

The temperature controller 72 is configured to adjust a temperature of the furnace internal space 23 by respectively controlling heat generating temperatures of the side heater 24 and the ceiling heater 26 of the heating apparatus 20. Specifically, the temperature controller 72 is configured to adjust a ratio of outputting the electric power capable of being supplied to the heater wire 86A in a unit time such that a difference between the temperature obtained from the temperature sensor 25A and a temperature setting value can be reduced. More specifically, according to the present embodiments, the temperature controller 72 is configured to adjust (control) a ratio RA of a turn-on time of the thyristor 92A to the unit time such that the difference between the temperature obtained from the temperature sensor 25A and the temperature setting value set in advance can be reduced. The term "unit time" in the present embodiments may refer to a time duration of one cycle of a sinusoidal wave of the power supply 84A, which is the AC power supply. While an example in which the temperature controller 72 controls an amount of the current of the heater driving apparatus 80A (the drive circuit 82A) is described above, the temperature controller 72 is configured to control the amount of the current of each of the heater driving apparatuses 80B, 80C, 80D and 80E in substantially the same manner as the heater driving apparatus 80A.

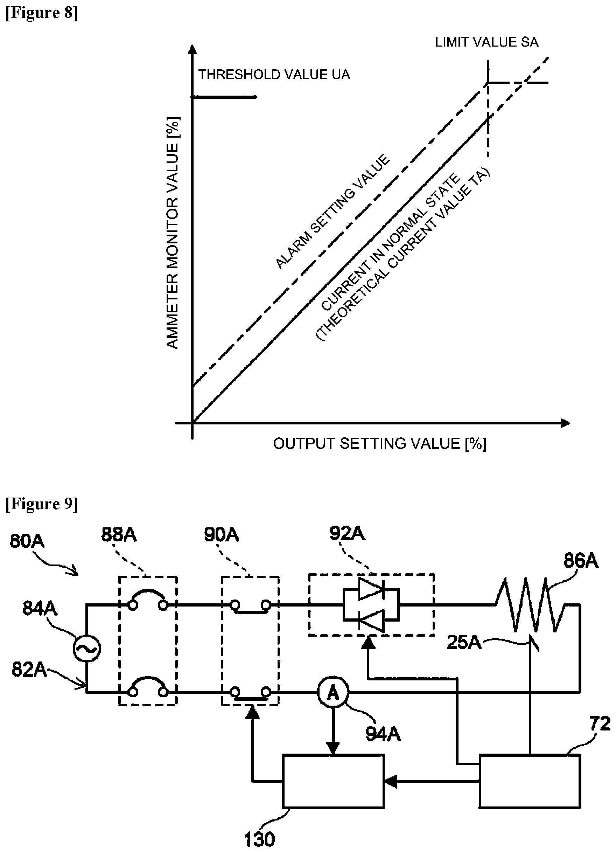

The abnormality detecting controller 74 is configured to compare an actually measured value of the current flowing through the drive circuit 82A (hereinafter, also referred to as a "current measurement value" as appropriate) in the heater driving apparatus 80A and a theoretical current value, and is configured to issue an alarm to the apparatus controller 70 in a case where it is determined that there is an abnormality in a component constituting the drive circuit as a result of a comparison. Specifically, the abnormality detecting controller 74 is configured to compare a current measurement value MA measured by the ammeter 94A and a theoretical current value TA (see FIG. 8) calculated based on the ratio of outputting the electric power to the heater wire 86A acquired from the temperature controller 72, and is configured to determine that there is the abnormality in a case where the current measurement value MA and the theoretical current value TA are different. More specifically, according to the present embodiments, the abnormality detecting controller 74 is configured to compare the current measurement value MA with the theoretical current value TA calculated based on the ratio RA of the turn-on time of the thyristor 92A to the unit time acquired from the temperature controller 72, and is configured to determine that there is the abnormality in a case where the current measurement value MA and the theoretical current value TA are different. While an example in which the abnormality detecting controller 74 performs an abnormality determination of the heater driving apparatus 80A (the drive circuit 82A) is described above, the abnormality detecting controller 74 is configured to perform the abnormality determination of each of the heater driving apparatuses 80B, 80C, 80D and 80E in substantially the same manner as the heater driving apparatus 80A. Hereinafter, a functional configuration of the abnormality detecting controller 74 will be described by using the heater driving apparatus 80A as an example. It is needless to say that the current measurement value MA and the theoretical current value TA are effective values (RMS).

The abnormality detecting controller 74 is configured to determine that there is the abnormality without comparing the current measurement value MA and the theoretical current value TA in a case where the current measurement value MA is equal to or greater than a threshold value UA (see FIG. 8) set in advance.

Further, the abnormality detecting controller 74 is configured to determine that there is the abnormality without calculating the theoretical current value TA in a case where the ratio of outputting the electric power acquired from the temperature controller 72 is greater than a limit value SA (see FIG. 8) of an output setting value. Specifically, according to the present embodiments, the abnormality detecting controller 74 is configured to determine that there is the abnormality without calculating the theoretical current value TA in a case where the ratio RA of turning on the thyristor 92A acquired from the temperature controller 72 is greater than the limit value SA of the output setting value.

Further, the abnormality detecting controller 74 is configured to change the contactor 90A to an open state in a case where it is determined that there is the abnormality without comparing the current measurement value MA and the theoretical current value TA. By setting the contactor 90A in the open state in a manner described above, the drive circuit 82A is opened and a supply of the electric power to the heater wire 86A is stopped.

Further, an alarm setting value LA may be set for the abnormality detecting controller 74. The abnormality detecting controller 74 is configured to determine that there is no abnormality (that is, configured to determine to be normal) in a case where a difference (absolute value of the difference) between the current measurement value MA and the theoretical current value TA is less than the alarm setting value LA, and is configured to determine that there is the abnormality in a case where the difference (absolute value of the difference) between the current measurement value MA and the theoretical current value TA is equal to or greater than the alarm setting value LA. Specifically, according to the present embodiments, the abnormality detecting controller 74 is configured to compare the current measurement value MA with the theoretical current value TA, and is configured to determine that there is the abnormality in a case where the current measurement value MA and the theoretical current value TA are different. However, the abnormality detecting controller 74 is further configured to determine that there is no abnormality again in a case where the difference (absolute value of the difference) between the current measurement value MA and the theoretical current value TA is less than the alarm setting value LA. On the other hand, in a case where the difference (absolute value of the difference) between the current measurement value MA and the theoretical current value TA is equal to or greater than the alarm setting value LA, the abnormality detecting controller 74 is further configured to determine that there is the abnormality, that is, the abnormality determination is continuously performed.

Further, in a film-forming step of the present embodiments, in a case where the abnormality detecting controller 74 compares the current measurement value MA with the theoretical current value TA and determines that there is the abnormality as a result of a comparison, that is, in a case where the current measurement value MA and the theoretical current value TA are different, the abnormality detecting controller 74 may be configured to transmit an abnormality determination result to the apparatus controller 70 and may be configured to open the contactor 90A and to stop the heater.

Further, in a temperature adjusting step (including a temperature elevating operation and a temperature lowering operation) of the present embodiments, the abnormality detecting controller 74 may be configured to compare the current measurement value MA with the theoretical current value TA, and may be configured to determine that there is the abnormality in a case where the current measurement value MA and the theoretical current value TA are different. However, it is preferable that the abnormality detecting controller 74 is further configured to determine that there is no abnormality in a case where the difference (absolute value of the difference) between the current measurement value MA and the theoretical current value TA is less than the alarm setting value LA, and it is preferable that the abnormality detecting controller 74 is further configured to determine that there is the abnormality in a case where the difference (absolute value of the difference) between the current measurement value MA and the theoretical current value TA is equal to or greater than the alarm setting value LA. That is, it is preferable to determine an alert in a case where the current measurement value MA and the theoretical current value TA are different and to determine that there is the abnormality in a case where the difference between the current measurement value MA and the theoretical current value TA is greater than the threshold value.

For example, it is preferable that the alarm setting value LA is set to be zero (0) in the film-forming step and is set to be a predetermined value other than 0 in the temperature adjusting step. The alarm setting value LA may also be changed depending on the step in a manner described above. In addition, it is possible to set a presence or absence of the abnormality determination depending on the step. Further, the abnormality detecting controller 74 of the present embodiments is configured to be capable of changing the alarm setting value LA in accordance with the ratio RA of turning on the thyristor 92A. Specifically, according to the present embodiments, the alarm setting value LA is not constant, but varies (proportionally) in accordance with the ratio RA of turning on the thyristor 92A, like an alarm setting value shown in FIG. 8. Further, the alarm setting value shown in FIG. 8 is obtained by adding the alarm setting value LA to the theoretical current value TA.

Further, according to the present embodiments, the alarm setting value can be changed for each heater driving apparatus. For example, the alarm setting value may be changed between the heater driving apparatus 80A for the heat generating zone 24A of the side heater 24 and the heater driving apparatus 80D for the heat generating zone 24D. However, the present disclosure is not limited to thereto, and the same alarm setting value may be set for an entirety of the heater driving apparatuses.

For example, the abnormality detecting controller 74 may include a first comparator 120, an acquisitor (which is an acquisition structure) 122, a calculator 124, a second comparator 126 and a third comparator 128.

The first comparator 120 is configured to compare the current measurement value MA with the threshold value UA.

The acquisitor 122 is configured to acquire the ratio of outputting the electric power from the temperature controller 72. Specifically, according to the present embodiments, the acquisitor 122 is configured to acquire the ratio RA of turning on the thyristor 92A from the temperature controller 72.

The calculator 124 is configured to calculate the theoretical current value TA based on the ratio of outputting the electric power acquired from the temperature controller 72. Specifically, according to the present embodiments, the calculator 124 is configured to calculate the theoretical current value TA based on the ratio RA of turning on the thyristor 92A acquired from the temperature controller 72.

The second comparator 126 is configured to compare the ratio of outputting the electric power acquired from the temperature controller 72 and the limit value SA of the output setting value. Specifically, according to the present embodiments, the second comparator 126 is configured to compare the ratio of turning on the thyristor 92A acquired from the temperature controller 72 and the limit value SA of the output setting value.

The third comparator 128 is configured to compare the current measurement value MA with the theoretical current value TA.

The flow rate controller 76 is configured to control the flow rate control valve 60 such that an actually measured value of the flow rate the gas measured by the flow rate sensor 58 is equal to a value of the flow rate of the gas set in advance, and is configured to control the flow rate of the gas introduced into the reaction tube 54 in the process chamber 55. Specifically, the flow controller 76 of the present embodiments is a mass flow controller (hereinafter, also referred to as an "MFC" as appropriate).

The pressure sensor 64 and the APC valve 66 are connected to the pressure controller 78. The pressure controller 78 is configured to control an opening degree of the APC valve 66 and a switching operation (which is an on and off operation) of a vacuum pump (not shown) based on a pressure value detected by the pressure sensor 64 such that an inner pressure of the process chamber 55 reaches a desired pressure at a desired timing.

Each the temperature controller 72, the abnormality detecting controller 74, the flow rate controller 76 and the pressure controller 78 is configured to individually control the component related thereto. Further, each of the temperature controller 72, the abnormality detecting controller 74, the flow rate controller 76 and the pressure controller 78 is configured to of report a status, an alarm indicating a failure detected based on sensor information and a value of each sensor connected thereto to the apparatus controller 70 in real time as the monitor data.

Each of the temperature controller 72, the abnormality detecting controller 74, the flow rate controller 76 and the pressure controller 78 according to the present embodiments may be embodied by a general computer system instead of a dedicated system. For example, by installing in the general computer system a program for executing the processing described above from a recording medium such as a flexible disk, a CD-ROM and a USB memory storing the program, each controller described above may be provided to perform a predetermined processing.

Further, a method of supplying the program can be appropriately selected. Instead of or in addition to being supplied through a predetermined recording medium as described above, for example, the program may be provided through a communication line, a communication network or a communication system. In such a case, for example, the program may be posted on a bulletin board on the communication network, and may be provided by being superimposed on a carrier wave via the communication network. Further, the program provided as described above may be executed to perform the predetermined processing described above under a control of an OS (operating system) of the substrate processing apparatus 10 just like any other application programs.

Subsequently, a configuration of the apparatus controller 70 will be described with reference to FIG. 3. The apparatus controller 70 may include a control structure 100 of the apparatus controller 70, an apparatus memory 102 such as a hard disk drive, an operation display structure 104 including a display capable of displaying various information and an input structure capable of receiving various instructions from an operating personnel; and a communication interface 106 capable of communicating with components inside and outside of the substrate processing apparatus 10. In the present specification, in addition to an apparatus operating personnel, the operating personnel may further include an apparatus manager, an apparatus engineer, a maintenance personnel and a worker. The control structure 100 of the apparatus controller 70 may be embodied by a computer including: a CPU (Central Processing Unit) 108 serving as a processor, a memory 110 such as a ROM (Read Only Memory) and a RAM (Random Access Memory) serving as a temporary memory. The computer constituting the control structure 100 of the apparatus controller 70 may further provided with a clock function (not shown).

In the apparatus memory 102, a recipe file such as a recipe in which process conditions and process sequences of the substrate processing are defined, a control program file for executing the recipe file, a parameter file in which parameters for executing the recipe are defined, an error processing program file, a parameter file for an error processing, various screen files including an input screen for inputting process parameters and various icon files and the like (which are not shown) are stored.

Further, in the apparatus memory 102, the monitor data including the sensor information output from each controller described above and an alarm history of the alarm indicating the failure detected by each controller based on the sensor information are stored.

Further, on an operation screen of the operation display structure 104, operation buttons serving as the input structure through which an operation instruction to a substrate transfer system or a substrate processing system is input may be provided.

The operation display structure 104 is configured to display the operation screen for operating the substrate processing apparatus 10. The operation display structure 104 is configured to display information on the operation screen of the operation display structure 104, based on the apparatus data generated in the substrate processing apparatus 10 via the operation screen. For example, the operation screen of the operation display structure 104 may be constituted by a touch panel using a liquid crystal display. The operation display structure 104 is configured to receive input data (input instruction) of the operating personnel via the operation screen and to transmit the input data to the apparatus controller 70. Further, the operation display structure 104 is configured to receive an instruction (control instruction) for executing a recipe stored in the memory (such as the RAM) 110 and the like or an appropriate substrate processing recipe (also referred to as a "process recipe") among a plurality of recipes stored in the apparatus memory 102, and is configured to transmit the instruction (control instruction) to the control structure 100 of the apparatus controller 70.

Further, the operation display structure 104 is configured to display the alarm information on the operation screen. The alarm information is information for specifying (or identifying) a type of the alarm indicating the failure detected by the controller among the event data generated in the substrate processing apparatus 10 on the operation screen.

Further, according to present embodiments, the apparatus controller 70 is configured to read the apparatus data by loading the screen files and data tables which are stored in advance by executing the various programs and the like when the apparatus controller 70 is started. In addition, the apparatus controller 70 is configured to display each screen (which indicates the operating state of the apparatus) on the operation display structure 104.

The communication interface 106 is connected to a component such as a switching hub. The apparatus controller 70 is configured to transmit and receive various data to and from an external computer or another controller (that is, the temperature controller 72, the abnormality detecting controller 74, the flow rate controller 76 and the pressure controller 78) in the substrate processing apparatus 10 via a network.

Further, the apparatus controller 70 may transmit the apparatus data such as a state of the substrate processing apparatus 10 to an external host computer via the network (not shown). The substrate processing of the substrate processing apparatus 10 is controlled by the control system based on each recipe file, each parameter file and the like stored in the apparatus memory 102.

The apparatus controller 70 is further configured to execute the process recipe including a plurality of steps as described above. The apparatus controller 70 causes (controls) the abnormality detecting controller 74 to compare the current measurement value of each drive circuit with the theoretical current value in the temperature adjusting step (including the temperature elevating operation and the temperature lowering operation). When comparing the values in the temperature adjusting step, the abnormality detecting controller 74 determines that there is no abnormality in a case where a difference (absolute value of the difference) between the current measurement value and the theoretical current value is less than the alarm setting value, determines that there is the abnormality in a case where the difference (absolute value of the difference) between the current measurement value and the theoretical current value is equal to or greater than the alarm setting value, and transmits a determination result to the apparatus controller 70. The apparatus controller 70 further causes (controls) the abnormality detecting controller 74 to compare the current measurement value of each drive circuit with the theoretical current value in the film-forming step. When comparing the values in the film-forming step, in a case where the abnormality detecting controller 74 determines that the current measurement value MA and the theoretical current value TA are different, the abnormality detecting controller 74 transmits the abnormality determination result to the apparatus controller 70, and opens the contactor 90A to stop the heater. Further, the apparatus controller 70 abnormally terminates the film-forming step.

For example, the apparatus controller 70 further is configured to cause (control) the abnormality detecting controller 74 to perform an abnormality detection of the drive circuit every time when the cycle of the sinusoidal wave of the AC power supply elapses (that is, for every unit time).

Subsequently, a substrate processing method including a predetermined processing step, which is performed by using the substrate processing apparatus 10 according to the present embodiments, will be described. The predetermined processing step will be described by way of an example in which the substrate processing (a film-forming step in the present embodiments) serving as a part of the manufacturing process of the semiconductor device is performed.

The substrate processing will be described by way of an example in which a film is formed on the substrate W (which is unprocessed) by supplying a predetermined process gas to the substrate W (which is unprocessed).

### <Substrate Loading Step>

First, the unprocessed substrates W are charged (supported) in the boat 68. After the unprocessed substrates W are charged, the boat 68 is loaded (transferred) into the process chamber 55 by the elevator (not shown). When the boat 68 is loaded into the process chamber 55, a lower end opening of the reaction tube 54 is airtightly closed (sealed) by the cap 69.

### <Pressure Adjusting Step>

The vacuum pump (not shown) vacuum-exhausts (decompresses and exhausts) the inside of the process chamber 55 such that the inner pressure of the process chamber 55 reaches and is maintained at a predetermined pressure (vacuum degree). The inner pressure of the process chamber 55 is measured by the pressure sensor 64, and the APC valve 66 is feedback-controlled based on pressure information measured by the pressure sensor 64.

### <Temperature Adjusting Step>

The side heater 24 and the ceiling heater 26 heat an inside of the reaction tube 54 and the inside of the process chamber 55 through the furnace internal space 23 such that a temperature of the unprocessed substrate W in the process chamber 55 reaches and is maintained at a predetermined temperature. Thereby, it is possible to maintain the inner temperature of the process chamber 55. In the present step, a state of an electric conduction to the ceiling heater 26 and each of the heat generating zones of the side heater 24 is feedback-controlled based on temperature information detected by each of the temperature sensors 25A, 25B, 25C, 25D and 25E such that a predetermined temperature distribution of the inner temperature of the process chamber 55 can be obtained.

Specifically, the ratio of turning on the thyristor configured to supply the electric power to the heater wire is adjusted such that a difference between a temperature of the heater and a temperature setting value can be reduced. Further, a rotation of the boat 68 and the unprocessed substrates W is started by a rotator (which is a rotating structure) (not shown). The side heater 24 and the ceiling heater 26 continuously heat the inside of the process chamber 55 until at least the film-forming step is completed. Further, according to the present embodiments, upon receiving a request from the apparatus controller 70 during the temperature adjusting step, the abnormality detecting controller 74 executes the abnormality detection at a predetermined interval.

### <Film-forming Step>

When the inner temperature of the process chamber 55 is stabilized at a process temperature (which is set in advance), the process gas is supplied to the unprocessed substrates W in the process chamber 55. The flow rate of the process gas is controlled to a desired flow rate by the flow rate controller 76, and the process gas whose flow rate is controlled (adjusted) is supplied into the process chamber 55 through the gas introduction pipe 56. Thereby, a predetermined processing (for example, a film-forming process) is performed on the substrate W. Subsequently, a supply of the process gas is stopped, and the inside of the process chamber 55 is vacuum-exhausted by the vacuum pump (not shown). In the present step, an inert gas may be supplied into the process chamber 55 (an inert gas purge). Further, according to the present embodiments, upon receiving a request from the apparatus controller 70 during the film-forming step, the abnormality detecting controller 74 executes the abnormality detection at a predetermined interval.

### <Substrate Unloading Step>

After a film of a predetermined thickness is formed, a cooling gas is supplied into the process chamber 55 to replace the inside of the process chamber 55 with the cooling gas, and the inner pressure of the process chamber 55 is returned to a normal pressure. Thereafter, the cap 69 is lowered by the elevator, and the boat 68 is unloaded from the reaction tube 54. Then, the substrates W (which are processed) are taken out from the boat 68.

Subsequently, an abnormality detecting method according to the present disclosure will be described. First, the apparatus controller 70 causes the abnormality detecting controller 74 to execute a first abnormality detecting method in the film-forming step, and causes the abnormality detecting controller 74 to execute a second abnormality detecting method in the temperature adjusting step. In addition, in the following description, the abnormality detecting method will be described by using one heater as an example.

### <First Abnormality Detecting Method>

First, the temperature of the heater is detected by the temperature sensor corresponding thereto (step S200). The detection temperature detected in the present step is transmitted to the temperature controller 72.

Subsequently, the current flowing through the drive circuit is measured by the ammeter corresponding thereto (step S202). The current value measured in the present step is transmitted to the abnormality detecting controller 74.

Subsequently, the abnormality detecting controller 74 acquires the current value (current measurement value) measured by the ammeter (step S204). Further, the abnormality detecting controller 74 acquires the ratio of turning on the thyristor corresponding thereto from the temperature controller 72 (step S206).

Subsequently, the abnormality detecting controller 74 compares the ratio of turning on the thyristor with the limit value of the output setting value (step S208). In a case where the ratio is greater than the limit value, the abnormality detecting controller 74 determines that there is the abnormality without calculating the theoretical current value, and then issues the alarm (step S210). Further, the abnormality detecting controller 74 opens the contactor 90A on the drive circuit (step S212). Thereby, the heater is stopped. On the other hand, in a case where the ratio is equal to or less than the limit value, a subsequent step S214 is performed.

Subsequently, the abnormality detecting controller 74 compares the current measurement value with the threshold value (step S214). However, in a case where the current measurement value is equal to or greater than the threshold value, the abnormality detecting controller 74 determines that there is the abnormality without comparing the current measurement value with the threshold value, and then issues the alarm (step S210). Further, the abnormality detecting controller 74 opens the contactor 90A on the drive circuit (step S212). Thereby, the heater is stopped. On the other hand, in a case where the ratio is equal to or less than the limit value, a subsequent step S216 is performed.

Subsequently, the abnormality detecting controller 74 calculates the theoretical current value based on the ratio of turning on the thyristor (step S216). Subsequently, the abnormality detecting controller 74 compares the current measurement value with the theoretical current value (step S218). In a case where the current measurement value and the theoretical current value are different, the abnormality detecting controller 74 determines that there is the abnormality, and then issues the alarm (step S210). Further, the abnormality detecting controller 74 opens the contactor 90A on the drive circuit (step S212). Thereby, the heater is stopped. On the other hand, in a case where the current measurement value and the theoretical current value are the same, the abnormality detecting controller 74 determines that there is no abnormality. In a case where the determination result from the abnormality detecting controller 74 is that there is no abnormality, the apparatus controller 70 continues the film-forming step by the substrate processing apparatus 10.

### <Second Abnormality Detecting Method>

First, the temperature of the heater is detected by the temperature sensor corresponding thereto (step S220). The detection temperature detected in the present step is transmitted to the temperature controller 72.

Subsequently, the current flowing through the drive circuit is measured by the ammeter corresponding thereto (step S222). The current value measured in the present step is transmitted to the abnormality detecting controller 74.

Subsequently, the abnormality detecting controller 74 acquires the current value (current measurement value) measured by the ammeter (step S224). Further, the abnormality detecting controller 74 acquires the ratio of turning on the thyristor corresponding thereto from the temperature controller 72 (step S226).

Subsequently, the abnormality detecting controller 74 compares the ratio of turning on the thyristor with the limit value of the output setting value (step S228). In a case where the ratio is greater than the limit value, the abnormality detecting controller 74 determines that there is the abnormality without calculating the theoretical current value, and then issues the alarm (step S230). Further, the abnormality detecting controller 74 opens the contactor 90A on the drive circuit (step S232). Thereby, the heater is stopped. On the other hand, in a case where the ratio is equal to or less than the limit value, a subsequent step S234 is performed.

Subsequently, the abnormality detecting controller 74 compares the current measurement value with the threshold value (step S234). However, in a case where the current measurement value is equal to or greater than the threshold value, the abnormality detecting controller 74 determines that there is the abnormality without comparing the current measurement value with the threshold value, and then issues the alarm (step S230). Further, the abnormality detecting controller 74 opens the contactor 90A on the drive circuit (step S232). Thereby, the heater is stopped. On the other hand, in a case where the ratio is equal to or less than the limit value, a subsequent step S236 is performed.

Subsequently, the abnormality detecting controller 74 calculates the theoretical current value based on the ratio of turning on the thyristor (step S236). Subsequently, the abnormality detecting controller 74 compares the current measurement value with the theoretical current value (step S238). In a case where the current measurement value and the theoretical current value are different, the abnormality detecting controller 74 determines that there is the abnormality, and then a step S240 is performed. On the other hand, in a case where the current measurement value and the theoretical current value are the same, the abnormality detecting controller 74 determines that there is no abnormality.

Subsequently, the abnormality detecting controller 74 calculates the difference (absolute value of the difference) between the current measurement value and the theoretical current value (step S240). Then, the abnormality detecting controller 74 compares the difference between the current measurement value and the theoretical current value with the alarm setting value (step S242). In a case where the difference is equal to or greater than the alarm setting value, the abnormality detecting controller 74 determines that there is the abnormality, and then issues the alarm (step S244). On the other hand, in a case where the difference is less than the alarm setting value, the abnormality detecting controller 74 determines that there is no abnormality. In a case where the determination result from the abnormality detecting controller 74 is that there is no abnormality, the apparatus controller 70 continues the temperature adjusting step by the substrate processing apparatus 10.

A program according to the present embodiments is an abnormality detecting program executed in the substrate processing apparatus 10 including: the heater configured to elevate the temperature of the process chamber 55 by generating the heat; the thyristor configured to supply the electric power to the heater wire included in the heater; the temperature sensor configured to detect the temperature of the heater; the temperature controller 72 configured to adjust (control) the ratio of turning on the thyristor (that is, the ratio of the turn-on time of the thyristor to the unit time) such that the difference between the temperature detected by the temperature sensor and the temperature setting value can be reduced; and the ammeter configured to measure the current flowing through the drive circuit. Further, the program according to the present embodiments causes the substrate processing apparatus 10 to perform: comparing the current measurement value measured by the ammeter and the theoretical current value calculated based on the ratio obtained from the temperature controller 72; and determining that there is the abnormality in a case where the current measurement value is different from the theoretical current value.

Subsequently, operations and effects of the present embodiments will be described. In a conventional substrate processing apparatus, there is a short circuit mode as a failure mode of a thyristor included in a heater drive circuit. When the thyristor is short-circuited, 100 % of the electric power from the AC power supply is applied to the heater. In such a state, since the temperature of the heater is elevated endlessly until it reaches a thermal equilibrium due to a cooling structure and the like, a defect in the substrate W may occur and a failure of the substrate processing apparatus may occur. Therefore, a protection structure may be provided to monitor the inner temperature of the process chamber and to cut off the electric power when the inner temperature of the process chamber is greater than a threshold value. However, when the thyristor fails and 100 % of the electric power is applied to the heater, a temperature elevation rate of the process chamber is faster than in a normal control state, and the temperature distribution in the process chamber tends to be non-uniform. Therefore, when the heater drive circuit is powered off, there is a possibility that the substrate processing apparatus may fail. On the other hand, in the substrate processing apparatus 10 according to the present embodiments, the current measurement value and the theoretical current value are compared, and in a case where the current measurement value and the theoretical current value are different, it is determined that there is the abnormality. Therefore, it is possible to reliably detect that any one of components constituting the drive circuit has failed. In addition, since it is possible to detect minute errors between the current measurement value and the theoretical current value, it is possible to detect a sign of a failure of the components constituting the drive circuit. As a result, according to the present embodiments, by cutting off the electric power to the heater by detecting an overcurrent that occurs when the thyristor is in a short-circuit failure, it is possible to suppress an occurrence of an accident due to an abnormal overheating of the heater.

Further, according to the present embodiments, by comparing the ratio of turning on the thyristor with the limit value of the output setting value, it is possible to determine that there is the abnormality (that is, any one of components constituting the drive circuit has failed) without calculating the theoretical current value in a case where the ratio of turning on the thyristor is greater than the limit value of the output setting value. Therefore, it is possible to reliably detect a disconnection of the heater wire.

Further, according to the present embodiments, by comparing the current measurement value with the threshold value, it is possible to determine that there is the abnormality without comparing the current measurement value with the theoretical current value in a case where the current measurement value is equal to or greater than the threshold value. That is, by comparing the current measurement value with the threshold value, it is possible to reliably detect an occurrence of the short-circuit failure of the thyristor. Further, according to the present embodiments, by detecting the minute errors between the current measurement value and the theoretical current value, it is possible to issue the alert (alarm) before the failure occurs in the components constituting the drive circuit. In addition, in the substrate processing apparatus 10 according to the present embodiments, in a case where the apparatus controller 70 receives the alert before the failure occurs in the components constituting the drive circuit, a maintenance operation can be performed without performing a subsequent batch process such that the short-circuit failure does not occur during the film-forming step.

Further, according to the present embodiments, in a case where it is determined that there is the abnormality without comparing the current measurement value with the theoretical current value, the contactor is changed to the open state. Therefore, even in a case where the overcurrent or the short-circuit failure of the thyristor occurs, it is possible to suppress an influence on normal components constituting the drive circuit. Further, it is also possible to suppress influences on the substrate W being processed or on the substrate processing apparatus 10.

Further, according to the present embodiments, it is possible to determine that there is the abnormality in a case where the difference between the current measurement value and the theoretical current value is greater that the limit value of the output setting value, and it is also possible to issue the alarm. Therefore, it is possible to detect details of the minute errors. As a result, for example, it is possible to estimate to what degree a sign of the abnormality occurs.

According to the present embodiments, it is possible to change the alarm setting value in accordance with the ratio of turning on the thyristor. In the present embodiments, it is considered that the load applied to the heater may also increase as the ratio of turning on the thyristor increases. Therefore, by increasing the alarm setting value as the ratio increases, it is possible to expect that the sign of the abnormality can be detected more accurately. Further, in a case where the ratio of turning on the thyristor is small, the alarm setting value may be set to zero.

Further, according to the present embodiments, the alarm setting value can be changed for each heater. In other words, the alarm setting value can be individually set for each heat generating zone of the side heater 24 and the ceiling heater 26. In a case where the substrate processing apparatus 10 is a vertical type apparatus, it is considered that the electric power supplied to the heat generating zone on a lower portion of the side heater 24 is large and that the load on the drive circuit is large. Therefore, in the heat generating zone on the lower portion of the side heater 24, for example, by setting the alarm setting value greater than that in the heat generating zone on an upper portion of the side heater 24, it is possible to expect that the sign of the abnormality can be detected more accurately. In addition, in the heat generating zone on the lower portion of the side heater 24, it is possible to monitor the sign of the abnormality by monitoring whether or not the difference between the current measurement value and the theoretical current value is equal to or greater than the alarm setting value, and in the heat generating zone on the upper portion, it is possible to detect the abnormality by comparing the theoretical current value with the current measurement value and detecting the presence or absence of the difference. In a manner as described above, it is possible to perform the abnormality detection in more detail.

Further, according to the present embodiments, in a case where the substrate processing apparatus 10 is the vertical type apparatus, it is considered that the electric power is large and the load on the drive circuit is large in the temperature elevating step and the temperature lowering step. Therefore, it is possible to monitor the sign of the abnormality by monitoring whether or not the difference between the current measurement value and the theoretical current value calculated from the ratio of turning on the thyristor is equal to or greater than the alarm setting value. In addition, since a constant temperature is maintained in the film-forming step, it is considered that the load is relatively stable. By comparing the theoretical current value calculated from the ratio of turning on the thyristor and the current measurement value in a manner described above and detecting the abnormality based on the presence or absence of the difference, it is possible to perform the abnormality detection more accurately and in more detail.

For example, in the substrate processing apparatus according to the embodiments described above, the abnormality determination for the heater driving apparatuses is performed by using the abnormality detecting controller 74. However, the present disclosure is not limited thereto. For example, the abnormality detecting controller 74 may be individually provided for each heater driving apparatus, and the abnormality detecting controller 74 corresponding to each heater driving apparatus may individually perform the abnormality determination. Further, after the abnormality determination, the contactor 90A is opened. However, the circuit breaker 88A may be opened.

For example, in the substrate processing apparatus according to the embodiments described above, a dedicated controller is used as the abnormality detecting controller 74. However, the present disclosure is not limited thereto. For example, a general computer 130 may be used as the abnormality detecting controller 74 as shown in FIG. 9. In such a case, by installing in the general computer 130 a program for executing a process related to the abnormality detection from a recording medium such as a flexible disk, a CD-ROM and a USB memory storing the program, it is possible to provide the controller for executing the process related to the abnormality detection.

For example, the substrate processing apparatus heats the furnace internal space 23 with the side heater 24 and the ceiling heater 26. However, the substrate processing apparatus may further include a cooling structure configured to cool the furnace internal space 23. As the cooling structure, for example, a structure configured to forcibly cool the furnace internal space 23 by supplying the cooling gas to the furnace internal space 23 may be used.

### [Industrial Applicability]

The present disclosure can be applied to an apparatus provided with a heating structure configured to heat an object to be processed. In particular, the present disclosure can also be applied to a technology related to the abnormality detection of the heating structure or a detection of the sign of the abnormality.

## Claims

1. A substrate processing apparatus comprising:
a process chamber (55) in which a substrate is processed;
a heat generator (24) configured to elevate a temperature of the process chamber (55);
a thyristor (92A) configured to supply an electric power to the heat generator (24);
a temperature detector (25A) configured to detect a temperature of the heat generator (24);
a temperature regulator (72) configured to adjust a ratio of turning on the thyristor (92A) such that a difference between a temperature detected from the temperature detector (25A) and a temperature setting value is reduced;
a measurer (94A) configured to measure a current flowing through a circuit containing the heat generator (24) and the thyristor (92A); and
an abnormality detector (74) configured to compare a current measurement value measured by the measurer (94A) and a theoretical current value calculated based on the ratio acquired from the temperature regulator (72) and to determine that there is an abnormality when the current measurement value and the theoretical current value are different, wherein an alarm setting value is set for the abnormality detector (74), wherein the abnormality detector (74) is further configured to determine that there is no abnormality when a difference between the current measurement value and the theoretical current value is less than the alarm setting value and to determine that there is the abnormality when the difference between the current measurement value and the theoretical current value is equal to or greater than the alarm setting value, and **characterized in that** the abnormality detector (74) is further configured to be capable of changing the alarm setting value in accordance with the ratio of turning on the thyristor (92A).

2. The substrate processing apparatus of claim 1, wherein the abnormality detector (74) is configured to determine that there is the abnormality without comparing the current measurement value and the theoretical current value when the current measurement value is equal to or greater than a threshold value.

3. The substrate processing apparatus of claim 1, wherein the abnormality detector (74) is configured to determine that there is the abnormality without calculating the theoretical current value when the ratio of turning on the thyristor (92A) is greater than a limit value of an output setting value.

4. The substrate processing apparatus of claim 2 or 3, wherein the abnormality detector (74) is connected to a contactor (90A) contained in the circuit, and wherein the abnormality detector (74) is configured to change the contactor (90A) to an open state when it is determined that there is the abnormality without comparing the current measurement value and the theoretical current value.

5. The substrate processing apparatus of claim 1, wherein the abnormality detector (74) comprises:
a first comparator (120) configured to compare the current measurement value measured by the measurer (94A) with a setting value;
an acquisitor (122) configured to acquire the ratio of turning on the thyristor (92A) from the temperature regulator (72);
a calculator (124) configured to calculate the theoretical current value based on the ratio of turning on the thyristor (92A);
a second comparator (126) configured to compare the ratio of turning on the thyristor (92A) with a limit value of an output setting value; and
a third comparator (128) configured to compare the current measurement value with the theoretical current value.

6. The substrate processing apparatus of claim 1, wherein the ratio of turning on the thyristor (92A) is equal to a time duration for the thyristor (92A) to be on with respect to one cycle of a sinusoidal wave of an AC power supply (84A) contained in the circuit.

7. The substrate processing apparatus of claim 1, further comprising
a plurality heat generating zones (24A, 24B, 24C, 24D) containing the heat generator (24), and
wherein the alarm setting value is capable of being changed for each of the plurality heat generating zones (24A, 24B, 24C, 24D).

8. The substrate processing apparatus of claim 1, further comprising
a controller configured to perform a process recipe containing a plurality of steps,
wherein the controller causes the abnormality detector (74) to perform an abnormality detection of determining that, in a temperature elevating step or a temperature lowering step, there is no abnormality when a difference between the current measurement value and the theoretical current value is less than an alarm setting value and that there is the abnormality when the difference between the current measurement value and the theoretical current value is equal to or greater than the alarm setting value.

9. The substrate processing apparatus of claim 1, further comprising
a controller configured to perform a process recipe containing a plurality of steps,
wherein the controller causes the abnormality detector (74) to perform an abnormality detection of determining that there is the abnormality when the current measurement value is different from the theoretical current value in a film-forming step.

10. The substrate processing apparatus of claim 9, wherein the controller is configured to abnormally terminate the film-forming step when the current measurement value is different from the theoretical current value.

11. The substrate processing apparatus of claim 1, wherein the controller further causes the abnormality detector (74) to perform the abnormality detection every time when one cycle of a sinusoidal wave of an AC power supply (84A) contained in the circuit elapses.

12. An abnormality detecting method comprising:
detecting a temperature of a heat generator (24) configured to elevate a temperature of a process chamber (55) by generating a heat;
adjusting a ratio of turning on a thyristor (92A) configured to supply an electric power to the heat generator (24) such that a difference between the temperature of the heat generator (24) and a temperature setting value is reduced;
measuring a current flowing through a circuit containing the heat generator (24) and the thyristor (92A);
comparing a current measurement value measured in measuring the current and a theoretical current value calculated in adjusting the ratio and determining that there is an abnormality when the current measurement value and the theoretical current value are different; and
setting an alarm setting value for an abnormality detector (74), wherein the abnormality detector (74) is further configured to determine that there is no abnormality when a difference between the current measurement value and the theoretical current value is less than the alarm setting value and to determine that there is the abnormality when the difference between the current measurement value and the theoretical current value is equal to or greater than the alarm setting value, and
**characterized in that** the mehtod further comprising:
the abnormality detector (74) is further configured to be capable of changing the alarm setting value in accordance with the ratio of turning on the thyristor (92A).

13. A method of manufacturing a semiconductor device, comprising the abnormality detecting method of claim 12, and further comprising:
heating a substrate provided in the process chamber (55) while supplying the electric power adjusted in adjusting the ratio to the heat generator (24);
wherein the steps of measuring and comparing are comprised in the heating step.

## Patentansprüche

1. Eine Substratverarbeitungsvorrichtung, die folgendes aufweist:
eine Verarbeitungskammer (55), in der ein Substrat verarbeitet wird;
eine Wärmeerzeugungseinrichtung (24), die konfiguriert ist, eine Temperatur der Verarbeitungskammer (55) zu erhöhen;
einen Thyristor (92A), der konfiguriert ist, eine elektrische Leistung an die Wärmeerzeugungseinrichtung (24) zu liefern;
eine Temperaturdetektionseinrichtung (25A), die konfiguriert ist, eine Temperatur der Wärmeerzeugungseinrichtung (24) zu detektieren;
eine Temperaturregeleinrichtung (72), die konfiguriert ist, ein Verhältnis des Anschaltens des Thyristors (92A) derart einzustellen, dass eine Differenz zwischen einer von der Temperaturdetektionseinrichtung (25A) detektierten Temperatur und einem Temperatureinstellwert verringert wird;
eine Messeinrichtung (94A), die konfiguriert ist, einen Strom zu messen, der durch eine Schaltung, welche die Wärmeerzeugungseinrichtung (24) und den Thyristor (92A) enthält, fließt; und
eine Anomaliedetektionseinrichtung (74), die konfiguriert ist, einen von der Messeinrichtung (94A) gemessenen Strommesswert und einen theoretischen Stromwert, der auf der Grundlage des von dem von der Temperaturregeleinrichtung (72) erfassten Verhältnisses berechnet wird, zu vergleichen, und zu bestimmen, dass es eine Anomalie gibt, wenn der Strommesswert und der theoretische Stromwert verschieden sind, wobei ein Alarmeinstellwert für die Anomaliedetektionseinrichtung (74) eingestellt wird, wobei die Anomaliedetektionseinrichtung (74) ferner konfiguriert ist, zu bestimmen, dass es keine Anomalie gibt, wenn eine Differenz zwischen dem Strommesswert und dem theoretischen Stromwert kleiner als der Alarmeinstellwert ist, und um zu bestimmen, dass es die Anomalie gibt, wenn die Differenz zwischen dem Strommesswert und dem theoretischen Stromwert gleich oder größer als der Alarmeinstellwert ist, und **dadurch gekennzeichnet, dass** die Anomaliedetektionseinrichtung (74) ferner konfiguriert ist, fähig zu sein, den Alarmeinstellwert gemäß dem Verhältnis des Anschaltens des Thyristors (92A) zu verändern.

2. Die Substratverarbeitungsvorrichtung nach Anspruch 1, wobei die Anomaliedetektionseinrichtung (74) konfiguriert ist, zu bestimmen, dass es die Anomalie gibt, ohne den Strommesswert und den theoretischen Stromwert zu vergleichen, wenn der Strommesswert gleich oder größer als ein Schwellenwert ist.

3. Die Substratverarbeitungsvorrichtung nach Anspruch 1, wobei die Anomaliedetektionseinrichtung (74) konfiguriert ist, zu bestimmen, dass es die Anomalie gibt, und zwar ohne den theoretischen Stromwert zu berechnen, wenn das Verhältnis des Anschaltens des Thyristors (92A) größer als ein Grenzwert eines Ausgabeeinstellwerts ist.

4. Die Substratverarbeitungsvorrichtung nach Anspruch 2 oder 3, wobei die Anomaliedetektionseinrichtung (74) mit einer in der Schaltung enthaltenen Kontaktiereinrichtung (90A) verbunden ist, und wobei die Anomaliedetektionseinrichtung (74) konfiguriert ist, die Kontaktiereinrichtung (90A) in einen offenen Zustand zu verändern, wenn bestimmt wird, dass es die Anomalie gibt, ohne den Strommesswert und den theoretischen Stromwert zu vergleichen.

5. Die Substratverarbeitungsvorrichtung nach Anspruch 1, wobei die Anomaliedetektionseinrichtung (74) folgendes aufweist:
eine erste Vergleichseinrichtung (120), die konfiguriert ist, den von der Messeinrichtung (94A) gemessenen Strommesswert mit einem Einstellwert zu vergleichen;
eine Erfassungseinrichtung (122), die konfiguriert ist, das Verhältnis des Anschaltens des Thyristors (92A) von der Temperaturregeleinrichtung (72) zu erfassen;
eine Berechnungseinrichtung (124), die konfiguriert ist, den theoretischen Stromwert auf der Grundlage des Verhältnisses des Anschaltens des Thyristors (92A) zu berechnen;
eine zweite Vergleichseinrichtung (126), die konfiguriert ist, das Verhältnis des Anschaltens des Thyristors (92A) mit einem Grenzwert eines Ausgabeeinstellwerts zu vergleichen; und
eine dritte Vergleichseinrichtung (128), die konfiguriert ist, den Strommesswert mit dem theoretischen Stromwert zu vergleichen.

6. Die Substratverarbeitungsvorrichtung nach Anspruch 1, wobei das Verhältnis des Anschaltens des Thyristors (92A) gleich einer Zeitdauer für den Thyristor (92A) ist, an zu sein, und zwar bezüglich eines Zyklus einer sinusartigen Welle einer Wechselspannungsversorgung (84A), welche in der Schaltung enthalten ist.

7. Die Substratverarbeitungsvorrichtung nach Anspruch 1, welche ferner
eine Vielzahl von Wärmeerzeugungszonen (24A, 24B, 24C, 24D), welche die Wärmeerzeugungseinrichtung (24) enthalten, aufweist, und
wobei der Alarmeinstellwert fähig ist, für jede der Vielzahl von Wärmeerzeugungszonen (24A, 24B, 24C, 24D) verändert zu werden.

8. Die Substratverarbeitungsvorrichtung nach Anspruch 1, die ferner
eine Steuereinrichtung, die konfiguriert ist, ein Prozessrezept, welches eine Vielzahl von Schritten enthält, durchzuführen, aufweist,
wobei die Steuereinrichtung die Anomaliedetektionseinrichtung (74) veranlasst, eine Anomaliedetektion durchzuführen, die bestimmt, dass, und zwar in einem Temperaturerhöhungsschritt oder einem Temperaturerniedrigungsschritt, es keine Anomalie gibt, wenn eine Differenz zwischen dem Strommesswert und dem theoretischen Stromwert kleiner als ein Alarmeinstellwert ist, und dass es die Anomalie gibt, wenn die Differenz zwischen dem Strommesswert und dem theoretischen Stromwert gleich oder größer als der Alarmeinstellwert ist.

9. Die Substratverarbeitungsvorrichtung nach Anspruch 1, die ferner
eine Steuereinrichtung, die konfiguriert ist, ein Prozessrezept, welches eine Vielzahl von Schritten enthält, durchzuführen, aufweist,
wobei die Steuereinrichtung die Anomaliedetektionseinrichtung (74) veranlasst, eine Anomaliedetektion des Bestimmens, dass es die Anomalie gibt, wenn der Strommesswert verschieden von dem theoretischen Stromwert in einem Schichtbildeschritt ist, durchzuführen.

10. Die Substratverarbeitungsvorrichtung nach Anspruch 9, wobei die Steuereinrichtung konfiguriert ist, den Schichtbildeschritt abnormal zu beenden, wenn der Strommesswert verschieden von dem theoretischen Stromwert ist.

11. Die Substratverarbeitungsvorrichtung nach Anspruch 1, wobei die Steuereinrichtung ferner die Anomaliedetektionseinrichtung (74) veranlasst, die Anomaliedetektion jedes Mal durchzuführen, wenn ein Zyklus einer sinusartigen Welle einer Wechselspannungsversorgung (84A), welche in der Schaltung enthalten ist, vergeht, durchzuführen.

12. Ein Anomaliedetektionsverfahren, welches folgendes aufweist:
Detektieren einer Temperatur einer Wärmeerzeugungseinrichtung (24), die konfiguriert ist, eine Temperatur einer Verarbeitungskammer (55) durch Erzeugen einer Wärme zu erhöhen;
Einstellen eines Verhältnisses des Anschaltens eines Thyristors (92A), der konfiguriert ist, eine elektrische Leistung an die Wärmeerzeugungseinrichtung (24) derart zu liefern, dass eine Differenz zwischen der Temperatur der Wärmeerzeugungseinrichtung (24) und einem Temperatureinstellwert verringert wird;
Messen eines Stroms, der durch eine Schaltung, welche die Wärmeerzeugungseinrichtung (24) und den Thyristor (92A) enthält, fließt;
Vergleichen eines Strommesswerts, der beim Messen des Stroms gemessen wird, und einen theoretischen Stromwert, der beim Einstellen des Verhältnisses berechnet wird, und Bestimmen, dass es eine Anomalie gibt, wenn der Strommesswert und der theoretische Stromwert verschieden sind; und
Einstellen eines Alarmeinstellwerts für eine Anomaliedetektionseinrichtung (74), wobei die Anomaliedetektionseinrichtung (74) ferner konfiguriert ist, zu bestimmen, dass es keine Anomalie gibt, wenn eine Differenz zwischen dem Strommesswert und dem theoretischen Stromwert kleiner als der Alarmeinstellwert ist, und zu bestimmen, dass es die Anomalie gibt, wenn die Differenz zwischen dem Strommesswert und dem theoretischen Stromwert gleich oder größer als der Alarmeinstellwert ist; und
**dadurch gekennzeichnet, dass** das Verfahren ferner folgendes aufweist:
die Anomaliedetektionseinrichtung (74) ist ferner konfiguriert, fähig zu sein, den Alarmeinstellwert gemäß dem Verhältnis des Anschaltens des Thyristors (92A) zu verändern.

13. Ein Verfahren des Herstellens einer Halbleitereinrichtung, welches das Anomaliedetektionsverfahren nach Anspruch 12 aufweist, und ferner folgendes aufweist:
Erwärmen eines Substrats, welches in der Verarbeitungskammer (55) vorgesehen ist, während die elektrische Leistung, die beim Einstellen des Verhältnisses an die Wärmeerzeugungseinrichtung (24) eingestellt wird, geliefert wird;
wobei die Schritte des Messens und Vergleichens in dem Erwärmungsschritt aufgewiesen werden.

## Revendications

1. Appareil de traitement de substrat, comprenant :
une chambre de traitement (55) dans laquelle un substrat est traité ;
un générateur de chaleur (24) configuré pour augmenter une température de la chambre de traitement (55) ;
un thyristor (92A) configuré pour fournir une alimentation électrique au générateur de chaleur (24) ;
un détecteur de température (25A) configuré pour détecter une température du générateur de chaleur (24) ;
un régulateur de température (72) configuré pour ajuster un rapport d'activation du thyristor (92A) de sorte qu'une différence entre une température détectée par le détecteur de température (25A) et une valeur de consigne de température soit réduite ;
un dispositif de mesure (94A) configuré pour mesurer un courant circulant à travers un circuit contenant le générateur de chaleur (24) et le thyristor (92A) ; et
un détecteur d'anomalie (74) configuré pour comparer une valeur de mesure de courant mesurée par le dispositif de mesure (94A) et une valeur de courant théorique calculée sur la base du rapport acquis du régulateur de température (72) et pour déterminer qu'il y a une anomalie lorsque la valeur de mesure de courant et la valeur de courant théorique sont différentes, dans lequel une valeur de consigne d'alarme est réglée pour le détecteur d'anomalie (74), dans lequel le détecteur d'anomalie (74) est en outre configuré pour déterminer qu'il n'y a pas d'anomalie lorsqu'une différence entre la valeur de mesure de courant et la valeur de courant théorique est inférieure à la valeur de consigne d'alarme et pour déterminer qu'il y a l'anomalie lorsque la différence entre la valeur de mesure de courant et la valeur de courant théorique est égale ou supérieure à la valeur de consigne d'alarme, et **caractérisé en ce que**
le détecteur d'anomalie (74) est en outre configuré pour être capable de modifier la valeur de consigne d'alarme en fonction du rapport d'activation du thyristor (92A).

2. Appareil de traitement de substrat selon la revendication 1, dans lequel le détecteur d'anomalie (74) est configuré pour déterminer qu'il y a l'anomalie sans comparer la valeur de mesure de courant et la valeur de courant théorique lorsque la valeur de mesure de courant est égale ou supérieure à une valeur seuil.

3. Appareil de traitement de substrat selon la revendication 1, dans lequel le détecteur d'anomalie (74) est configuré pour déterminer qu'il y a l'anomalie sans calculer la valeur de courant théorique lorsque le rapport d'activation du thyristor (92A) est supérieur à une valeur limite d'une valeur de consigne de sortie.

4. Appareil de traitement de substrat selon la revendication 2 ou 3, dans lequel le détecteur d'anomalie (74) est connecté à un contacteur (90A) contenu dans le circuit, et dans lequel le détecteur d'anomalie (74) est configuré pour faire passer le contacteur (90A) à un état ouvert lorsqu'il est déterminé qu'il y a l'anomalie sans comparer la valeur de mesure de courant et la valeur de courant théorique.

5. Appareil de traitement de substrat selon la revendication 1, dans lequel le détecteur d'anomalie (74) comprend :
un premier comparateur (120) configuré pour comparer la valeur de mesure de courant mesurée par le dispositif de mesure (94A) à une valeur de consigne ;
un dispositif d'acquisition (122) configuré pour acquérir le rapport d'activation du thyristor (92A) à partir du régulateur de température (72) ;
un calculateur (124) configuré pour calculer la valeur de courant théorique sur la base du rapport d'activation du thyristor (92A) ;
un deuxième comparateur (126) configuré pour comparer le rapport d'activation du thyristor (92A) à une valeur limite d'une valeur de consigne de sortie ; et
un troisième comparateur (128) configuré pour comparer la valeur de mesure de courant à la valeur de courant théorique.

6. Appareil de traitement de substrat selon la revendication 1, dans lequel le rapport d'activation du thyristor (92A) est égal à une durée pendant laquelle le thyristor (92A) est activé par rapport à un cycle d'une onde sinusoïdale d'une source de puissance CA (84A) contenue dans le circuit.

7. Appareil de traitement de substrat selon la revendication 1, comprenant en outre
une pluralité de zones de génération de chaleur (24A, 24B, 24C, 24D) contenant le générateur de chaleur (24), et
dans lequel la valeur de consigne d'alarme est apte à être modifiée pour chacune de la pluralité de zones de génération de chaleur (24A, 24B, 24C, 24D).

8. Appareil de traitement de substrat selon la revendication 1, comprenant en outre
un contrôleur configuré pour réaliser une recette de traitement contenant une pluralité d'étapes,
dans lequel le contrôleur amène le détecteur d'anomalie (74) à réaliser une détection d'anomalie consistant à déterminer que, dans une étape d'élévation de température ou une étape d'abaissement de température, il n'y a pas d'anomalie lorsqu'une différence entre la valeur de mesure de courant et la valeur de courant théorique est inférieure à une valeur de consigne d'alarme et qu'il y a l'anomalie lorsque la différence entre la valeur de mesure de courant et la valeur de courant théorique est égale ou supérieure à la valeur de consigne d'alarme.

9. Appareil de traitement de substrat selon la revendication 1, comprenant en outre
un contrôleur configuré pour réaliser une recette de traitement contenant une pluralité d'étapes,
dans lequel le contrôleur amène le détecteur d'anomalie (74) à réaliser une détection d'anomalie consistant à déterminer qu'il y a l'anomalie lorsque la valeur de mesure de courant est différente de la valeur de courant théorique dans une étape de formation de film.

10. Appareil de traitement de substrat selon la revendication 9, dans lequel le contrôleur est configuré pour terminer anormalement l'étape de formation de film lorsque la valeur de mesure de courant est différente de la valeur de courant théorique.

11. Appareil de traitement de substrat selon la revendication 1, dans lequel le contrôleur amène en outre le détecteur d'anomalie (74) à réaliser la détection d'anomalie chaque fois qu'un cycle d'une onde sinusoïdale d'une source de puissance CA (84A) contenue dans le circuit s'écoule.

12. Procédé de détection d'anomalie comprenant :
la détection d'une température d'un générateur de chaleur (24) configuré pour augmenter une température d'une chambre de traitement (55) en générant une chaleur ;
l'ajustement d'un rapport d'activation d'un thyristor (92A) configuré pour fournir une alimentation électrique au générateur de chaleur (24) de sorte qu'une différence entre la température du générateur de chaleur (24) et une valeur de consigne de température soit réduite ;
la mesure d'un courant circulant à travers un circuit contenant le générateur de chaleur (24) et le thyristor (92A) ;
la comparaison d'une valeur de mesure de courant mesurée lors de la mesure du courant et d'une valeur de courant théorique calculée lors de l'ajustement du rapport et la détermination qu'il y a une anomalie lorsque la valeur de mesure de courant et la valeur de courant théorique sont différentes ; et
le réglage d'une valeur de consigne d'alarme pour un détecteur d'anomalie (74), dans lequel le détecteur d'anomalie (74) est en outre configuré pour déterminer qu'il n'y a pas d'anomalie lorsqu'une différence entre la valeur de mesure de courant et la valeur de courant théorique est inférieure à la valeur de consigne d'alarme et pour déterminer qu'il y a l'anomalie lorsque la différence entre la valeur de mesure de courant et la valeur de courant théorique est égale ou supérieure à la valeur de consigne d'alarme, et
**caractérisé en ce que** le procédé comprend en outre :
le détecteur d'anomalie (74) est en outre configuré pour être capable de modifier la valeur de consigne d'alarme en fonction du rapport d'activation du thyristor (92A).

13. Procédé de fabrication d'un dispositif semiconducteur, comprenant le procédé de détection d'anomalie selon la revendication 12, et comprenant en outre :
le chauffage d'un substrat prévu dans la chambre de traitement (55) tout en fournissant l'alimentation électrique ajustée lors de l'ajustement du rapport au générateur de chaleur (24) ;
dans lequel les étapes de mesure et de comparaison sont comprises dans l'étape de chauffage.
